# EUROPEAN PATENT SPECIFICATION

(11) **EP 2 418 738 B1**
(45) Date of publication and mention of the grant of the patent: **13.07.2016**
(21) Application number: 10013458.4
(22) Date of filing: 08.10.2010
(51) Int. Cl.: H01R 4/48, H01R 12/51, H05K 3/32

(54) **Terminal for connecting wires to printed circuit boards**
Klemmen zum Anschließen von Drähten an Leiterplatten
Terminal pour connecter des câbles à des cartes de circuit imprimé

(30) Priority: 05.08.2010 IN DE18532010
(43) Date of publication of application: 15.02.2012
(73) Proprietor: Tyco Electronics Nederland B.V., 5222 AR's-Hertogenbosch (NL); Tyco Electronics Corporation India PVT, Limited, Bangalore, 560048 (IN)
(72) Inventor: Premjith, C. H., Bangalore 560035 (IN); Van der Bruggen, Ton, 5262 SL Vught (NL); Westen, Mark, Bangalore 560066 (IN)
(74) Representative: Grünecker Patent- und Rechtsanwälte PartG mbB

(56) References cited:
- EP-A2- 1 081 790
- WO-A2-2007/119068
- DE-A1-102007 017 593
- DE-B- 1 105 937
- DE-C1- 4 237 733
- DE-U1-202009 008 692
- US-A- 1 357 926
- US-B1- 7 618 279

## Description

The invention relates to a poke-in terminal for electrically connecting at least one wire to a printed circuit board, comprising at least one connecting portion for mounting the terminal on the printed circuit board, and a wire receptacle for receiving a wire in an insertion direction, the wire receptacle comprising a wire chamber and a wire retainer, wherein the terminal is provided with a retainer spring resiliently supporting the wire retainer and wherein the wire retainer, at least at an unmated state of the terminal, extends into the wire chamber and is adapted to be deflected resiliently by the wire in an outward direction.

Terminals of the above mentioned type are used for electrically connecting electrical devices, for example lighting applications, to printed circuit boards (PCBs). The terminals allow for mounting a cable or wire to a printed circuit board (PCB) by inserting the wire into the wire receptacle. The wire can be mounted screwless and without soldering. Within the wire receptacle, the wire retainer clamps the wire and thereby retains the wire. Thus, mounting of the wire on the printed circuit board is facilitated distinctly.

Preferentially, the terminal is configured as poke-in terminal, i.e. the wire can be mounted on the PCB simply by poking the wire into the wire receptacle. An insertion force can be exerted directly onto the wire or the cable comprising the wire, to deflect the retainer and to move the wire into the wire receptacle. Thus, no more mounting steps are necessary for connecting the wire to the PCB electrically and mechanically.

Due to the increased miniaturization of electronic articles, there is a need for miniaturized terminals which allow for connecting cables without soldering. A problem which arises in the known terminals is that small cables having a small cross section, in particular of less than AWG (American Wire Gauge) 20 or 0,518 mm², are not retained reliably.

DE 20 2009 008 692 U1 refers to a terminal having retaining units provided at a front part of a flat spring and an inner section, acting together for locking a free end of the inner section in a position in which the end limits a passage cross-section for an electrical conductor. The inner section extends parallel to a base of the terminal and the front part is adjusted in such a manner that it is elastically deformed for causing a relative movement between the free end and the front part and arranging the free end in another position in which the free end reduces the cross-section of the passage for clamping the conductor.

WO 2007/119068 A2 refers to a connector, for example for coupling a wire to an electrical circuit board. The connector comprises a first coupling element and a second coupling element offset from the first in an axial direction. The first and second coupling elements are arranged to in use receive a body there-between and to impart a shearing force on the body in a direction substantially perpendicular to the axial direction to hold the body in place with a connector.

WO 2007/119068 A2 provides a connector, for example for coupling a wire to an electrical circuit board. The connector comprises a first coupling element and a second coupling element offset from the first in an axial direction. The first and second coupling elements are arranged to in use receive a body, e.g. a wire there-between and to impart a shearing force on the body in a direction substantially perpendicular to the axial, direction, to hold the body in place with the connector. The first and second coupling elements are biased relative to one another, so the body is held in place by the force imparted by the coupling elements.

US 7,618,279 discloses an electrical contact poke-in terminal for an electrical connector that generally includes a main contact body, a cantilevered portion extending upwardly from one end of the body and a stiffener extending the entire length of the main contact body for providing rigidity to the main contact body.

EP 1 081 790 A2 which is considered to represent the closest prior art discloses a spring clip for connecting an electrical connector, including a support leg mounted generally parallel with and spaced from a bus bar, and a clamping leg for biasing an electrical conductor toward lateral electrical engagement with the bus bar. The contact clamping leg includes a stepped portion that terminates in an offset terminal portion that biases the conductor in lateral engagement with the bus bar, which terminal portion carries a clamping edge that resists withdrawal of the conductor from the contact. In order to disconnect the conductor from the contact, the device is provided for displacing the clamping leg from the bus bar, thereby to permit withdrawal of the conductor from the contact.

Therefore, the object of the invention is to provide a terminal for reliably connecting thin wires to a PCB, which is suitable for miniature or sub-miniature applications and for connecting 19 AWG wires or wires having a smaller cross-sectional area. In particular, the present invention aims at providing a terminal for reliably connecting 24 AWG or wires having a cross-sectional area of 0,205 mm² or less.

This object is achieved by the present invention, with respect to a terminal as mentioned above, in that the retainer spring has at least one spring leg, the spring leg extending substantially perpendicularly to the insertion direction.

The retainer spring improves the elasticity of the wire retainer and increases its maximum resilient deflection. Thus, in spite of miniaturized dimensions of the terminal, a wire can be re-terminated several times, wherein the resilience of the wire retainer and the resulting retaining force is maintained.

The solution according to the invention may be combined in any way with the following further advantageous embodiments respectively and further improved.

In a first advantageous embodiment, the wire retainer and the retainer spring can be configured to be deflected resiliently by a predetermined insertion force acting on the retainer, the wire retainer being configured to be less deflected than the retainer spring. Hence, the bigger part of the deflection of the wire retainer is realized by a deflection of the retainer spring, a smaller part of the deflection of the wire retainer is produced by a deflection of the wire retainer itself. The insertion force can be generated by poking the cable or wire into the terminal. Solid or tinned stranded wire may be used for the poke-in termination. As the wire retainer extends into the wire chamber, the wire retainer is pushed by the wire in an outward direction when the wire is inserted. The insertion force acts through the wire onto the wire retainer, resulting in a deflection of the wire retainer and of the retainer spring supporting the wire retainer.

To provide an increased retaining force, the wire retainer and the retainer spring can be arranged in series. The retainer spring and the wire retainer can be arranged in such a way that, when a wire is poked in, the wire retainer is acting or deflected first and then the retainer spring is providing sufficient retaining force to the wire.According to another advantageous embodiment, the wire retainer and the retainer spring can be arranged in such a way that they act simultaneously. The wire retainer and the retainer spring can be configured to act simultaneously on a wire received by the wire receptacle. Hence, a greater retaining force may be provided.

To increase the maximum resilient deflection of the retainer spring with respect to the maximum resilient deflection of the retainer, the resiliently deformable or bendable length of the retainer spring can be considerably longer than the resiliently deformable length of the wire retainer. For example, the resiliently deformable length of the retainer spring can be at least twice as long as the resiliently deformable length of the wire retainer. The stiffness or modules of resilience of the wire retainer can be greater than the stiffness or modules of resilience of the retainer spring.

Preferably, the inner dimensions of the wire chamber are fitted to the outer dimensions of the wire to be inserted. The outer surface of the wire can abut the inner surfaces of the wire chamber at at least two points, wherein the retainer presses the wire against the inner surfaces of the wire chamber.

For engaging the wire frictionally and/or by a positive lock, the wire retainer may be provided with a holding portion, which at a mated state abuts or engages with the wire. The holding portion can at a mated state, i.e. when a wire is inserted into the wire receptacle, deform the wire to build up a positive lock.

In a further advantageous embodiment of the terminal according to the invention, the wire retainer may protrude from the retainer spring substantially in insertion direction. The wire retainer may extend slanted or inclined into the wire chamber and, at a mated state of the terminal, in the direction of an inserted wire. A holding portion at an end of the wire retainer can protrude into the wire chamber and press onto the wire for fastening the wire reliably to the terminal and the underlying PCB.

In another advantageous embodiment of a terminal according to the invention, the retainer spring can be provided with an opening, the wire retainer protruding into the opening. The opening may be arranged at a centered area of the spring. This allows for an essentially centered position of the wire retainer on the retainer spring and a symmetrical deflection of the retainer spring without torsion, in order to achieve an optimized spring force and a maximum utilization of material.

To reduce the overall dimensions of the terminal, the retainer spring may be arranged around the wire chamber, surrounding the wire chamber at least sectionally.

The wire retainer may protrude from the spring leg. Thus, in face of miniaturized dimensions of the terminal the resilient section of the retainer spring and the possible resilient deflection of the retainer is increased. For a more compact configuration of the terminal, the wire retainer preferentially protrudes from the spring leg in insertion direction or perpendicularly to a longitudinal direction of the spring leg.

The opening of the retainer spring can be framed by the at least one spring leg. For an essentially straight or symmetric spring force, the retainer spring can be provided with two spring legs, the spring legs extending in parallel with each other. The two spring legs may frame the opening of the spring or be part of a closed frame bordering the opening.

In a further advantageous embodiment of a terminal according to the invention, the terminal may comprise a base portion which borders on the wire chamber, the retainer spring and the connecting portion protruding from the base portion. The base portion can provide a bedding for the wire and/or a stable supporting structure for the components of the terminal.

To support a wire received in the wire chamber, the terminal can comprise a back portion. The back portion and the retainer spring may extend from the base portion on opposite sides of the base portion and/or on opposite sides with respect to the wire receptacle.

In order to facilitate mounting of the terminal on a PCB, the terminal can be provided with a picking platform. The picking platform may protrude from the back portion and constitute a picking face. Preferentially, the picking face points against a mounting direction and/or extends substantially perpendicularly to a mounting direction and/or in parallel with the printed circuit board.

To increase the operation space of the retainer spring and to further reduce the overall dimensions of the terminal, the back portion can be provided with an aperture, the retainer spring extending into or through the aperture. In this way, the retainer spring can be enlarged or elongated in the direction of the back portion and be deflected without colliding with the back portion.

For connecting the terminal to a PCB, for example by soldering, the terminal may comprise at least one or at least two connecting portions. The at least one or two connecting portions may protrude from the base portion in a mounting direction or perpendicularly to the mounting direction. The connecting portions can be configured for soldering on the PCB, in particular by reflow soldering. The distance between two connecting portions can be increased by arms extending from the base portion of the terminal in opposite directions. The connecting portions or soldering portions can be bent in mounting direction or in the direction of the PCB.

For a cost-saving, large scale production, the terminal can be integrally formed from one piece of sheet metal. The sheet metal can be made of copper alloy. To improve the electrical properties, the terminal can be nickel plated. The nickel plating can be at least 1.27 µm. Further, the terminal can have a tin plating of at least 1.27 µm up to 2.54 µm. The thickness of the sheet for bending the terminal can be about 0.3 mm. Preferably, the thickness of the sheet for manufacturing the terminal is about 0.32 mm. Thinner material also may be used.

The terminal can be designed for 24 AWG wires or for wires having a higher AWG, i.e. a smaller cross-sectional area.

The terminal can be configured for a repeated termination of a wire. Preferentially, the terminal is configured for reliably re-terminating a wire at least two times, without or with an insignificant loss of resilience of the retainer and/or the retainer spring.

The wire chamber can have a polygonal shape. To facilitate bending the terminal from a piece of sheet metal, the wire chamber may have a triangular shape. For receiving a wire having a circular cross section, the triangular shape may border at three points on a circular area, a circular section or a circular, cylindrical volume, which can correspond to the shape of a wire to be received. The wire retainer preferably extends into the circular section or cylindrical volume. The circular section or cylindrical volume of the wire chamber can correspond to a volume of a section or a cross-sectional area of AWG 24 wires or wires having a higher AWG. Preferentially, the wire chamber has two openings on opposing ends to let a received wire pass the chamber.

The invention is described hereinafter by means of example referring to an example of an embodiment with reference to the drawings. The various features of the described embodiments and the advantages to be achieved with it can be combined or omitted independently of one another, as can already be seen from the above configurations. In the drawings:
- Fig. 1: is a schematic perspective top view of a terminal configured according to the invention;
- Fig. 2: is a schematic perspective bottom view of a terminal configured according to the invention;
- Fig. 3: is a schematic cross-sectional view of a terminal according to section plane III-III of Fig. 5;
- Fig. 4: is a schematic side view of a terminal configured according to the invention;
- Fig. 5: is a schematic back view of a terminal configured according to the invention;
- Fig. 6: is a schematic cross-sectional top view of a terminal according to section plane VI-VI of Fig. 4.

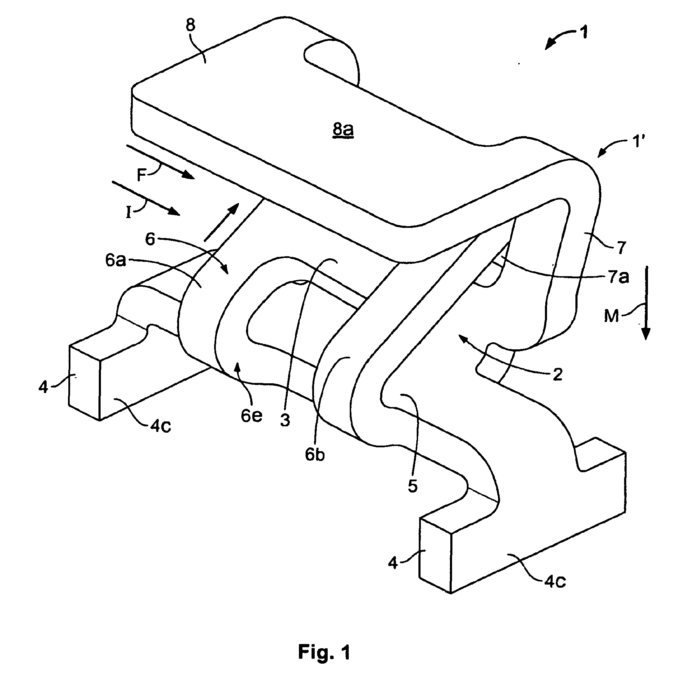

First of all, the construction of a terminal 1 configured according to the invention will be described with reference to Fig. 1.

The terminal 1 is configured as a poke-in terminal i.e., a wire can be connected electrically and mechanically to the terminal by poking the wire into the terminal 1. The terminal is integrally formed from one piece of sheet metal 1'. The sheet metal can be made of any type of alloy, preferably copper alloy.

For receiving at least a contact section of the wire, the terminal comprises a wire receptacle 2. The wire receptacle 2 is provided with a wire retainer 3 which, in a mated state of the terminal 1, in which a wire is received by the wire receptacle 2, presses onto the wire to retain the wire against external traction forces acting onto the wire or cable. The wire retainer 3 protrudes from a retainer spring 6. The wire retainer 3 and the retainer spring 6 are arranged in series so that when the wire 11 is pushed in, wire retainer 3 acts first and then the retainer spring 6 acts next. This arrangement is to provide an increased retaining force to the wire. When mounting a wire on the terminal, an insertion force F, directed in insertion direction I, can be exerted directly onto the wire or a cable comprising the wire to be received, to deflect the retainer 3 and the retainer spring 6 and to move the wire into the wire receptacle 2.

Connecting portions 4 on opposing ends of the terminal 1 are adapted for soldering the terminal 1 onto a printed circuit board (PCB). They protrude from a central base portion 5 and extend in a mounting direction M or in a direction of an underlying printed circuit board. The connecting portions 4 comprise soldering portions 4c and arms 4a, wherein the arms extend between the soldering portions 4c and the base portion 5 and are bent in mounting direction M.

The retainer spring 6 has two spring legs 6a, 6b which extend substantially perpendicularly to the insertion direction I. The wire retainer 3 may protrude from the spring leg 6a. Thus, the possible resilient deflection of the retainer 3 is increased. For a more compact configuration of the terminal 1, the wire retainer preferentially protrudes from the spring leg 6a in insertion direction I or perpendicularly to the longitudinal direction L of the retainer spring 6 or the spring leg 6a.

The back portion 7 serves to support a wire received by the wire receptacle 2. Further, the back portion 7 forms a holder or frame for a picking platform 8 protruding from the back portion 7 and forming a picking face 8a extending substantially perpendicularly to the mounting direction M. The picking face 8a is substantially planar and allows for coupling the terminal to a picking head of a vacuum picker for positioning of the terminal on the PCB.

The back portion 7 has an aperture 7a, the spring legs 6a, 6b extending into the aperture 7a. The aperture 7a provides space for a movement of the retainer spring when a wire is inserted into the terminal in insertion direction I.

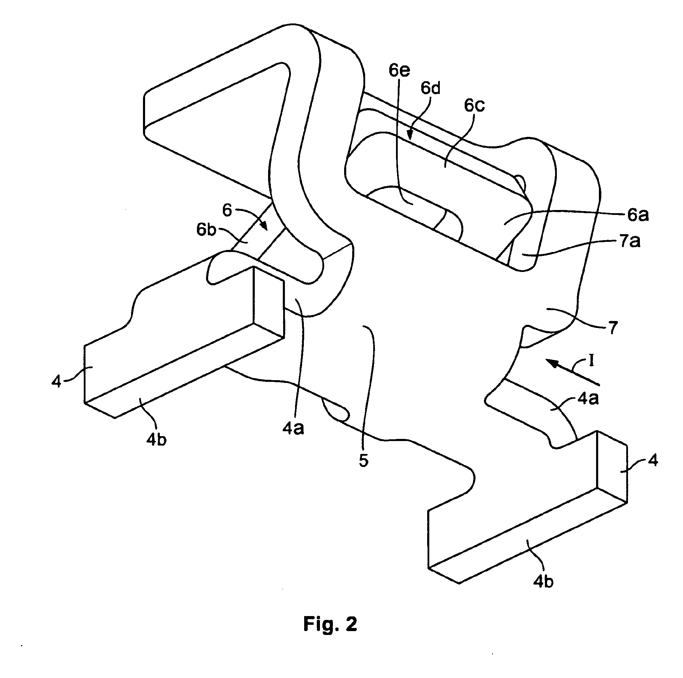

Fig. 2 is a perspective bottom view of a terminal according to the invention. The spring legs 6a, 6b of the retainer spring 6 extend into the aperture 7a of the back portion 7. To form a self-supporting spring body, the spring legs 6a, 6b are coupled or connected to each other by a coupling portion 6c. The coupling portion 6c spans the spring legs 6a, 6b in parallel with the insertion direction I and is, at least sectionally arranged within the aperture 7a. Together with the coupling section 6c, the spring legs 6a, 6b constitute a frame 6d having an opening 6e. The wire retainer 3 (see Fig. 1) is arranged within the opening 6e.

The distance between the connecting portions 4 is increased by the arms 4a, which extend in or against the insertion direction I from the base portion 5. Thereby, the support surfaces 4b of the connecting portions 4 have an increased distance in insertion direction I, which improves the support of the terminal on the PCB against turning moments resulting from forces acting on a received wire.

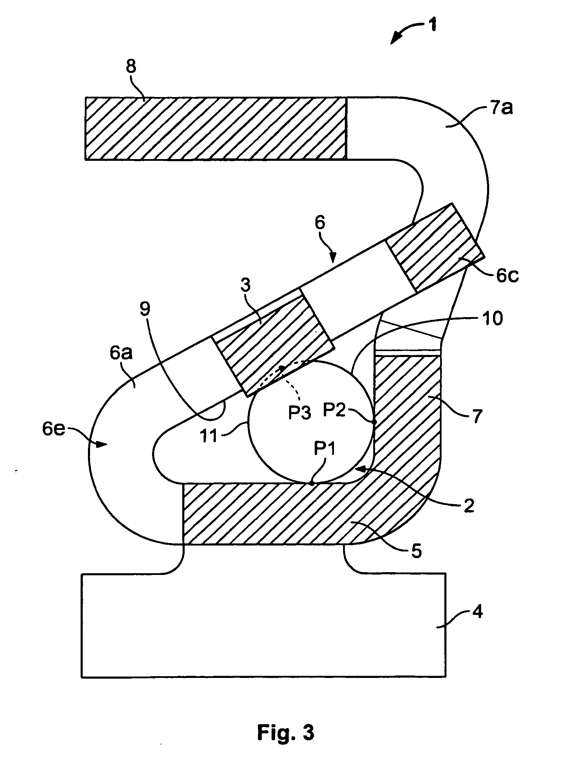

Fig. 3 is a cross sectional side view of a terminal according to the invention. The spring legs 6a and 6b (not shown), the base portion 5, and the back portion 7 together frame a polygonal shape 9 configured as an essentially triangular shape 9' within which the wire receptacle 2 is arranged. The triangular shape 9' can be configured to border on a circular area 10.

For receiving a wire 11 having a circular cross section, the triangular shape 9' may border at three points P1, P2, P3 on the circular area 10 or a circular, cylindrical volume having a circular area 10, which can correspond to the shape of a wire to be received. The base portion 5 and the back portion 7 may constitute a guidance for guiding a wire into the wire receptacle. The wire can be guided in the terminal 1 using the inner surface of base portion 5 and the inner surface of back portion 7. The wire retainer 3 preferably extends into the circular area 10 or cylindrical volume. The circular area or cylindrical volume of the wire chamber 2a can correspond to a volume of a section or a cross-sectional area of AWG 24 wires or wires having a higher AWG.

Inner surfaces of the back portion 7, the base portion 5 and the retainer spring 6 may border on the circular area 10. To generate a positive and/or frictional lock between the retainer and a wire received by the wire receptacle, the wire retainer 3 may extend into the circular area 10 and, at a mated state of the terminal, press onto a wire 11 arranged within the wire receptacle 2.

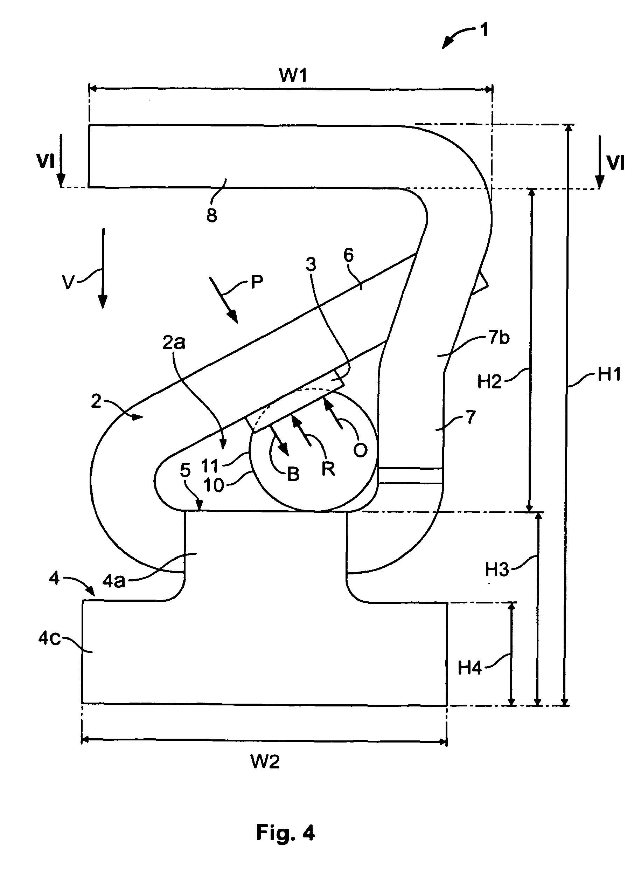

Fig. 4 is a schematic side view of a terminal 1 configured according to the invention. The wire retainer 3 and the retainer spring 6 are configured to be deflected resiliently by a predetermined insertion force F (see Fig. 1), which can be exerted through a wire 11 when poked in. When the wire 11 abuts the wire retainer 3, the insertion force F results in a release force R acting perpendicularly to the insertion direction I onto the wire retainer 3. Thereby, the wire retainer 3 is moved in an outward direction O to release the wire receptacle 2. According to the invention, the wire retainer 3 is configured to be deflected less than the retainer spring 6. After insertion of a wire, a retaining force B is generated by the spring 6 and the wire retainer 3. The wire retainer 3 is pressed onto the wire and thereby blocks a movement of the wire against insertion direction I.

The terminal 1 may have an overall height H1, which can be about 3 mm, and an overall width W1, which can be about 2 mm. The picking platform 8 can span the overall width W1 and thereby roof-like cover the underlying portions of the terminal 1. The picking platform 8 and the base portion 5 can be arranged at a distance or height H2 of about 1.7 mm. The height H4 of a soldering portion 4c may correspond to the height of arms 4a. The height H3 of the contact portion 4 can be about twice the height H4 of a soldering portion 4c.

The wire retainer 3 is bent in a pressing direction P and extends into the wire chamber 2a, framed by the back portion 7, the base portion 5 and the retainer spring 6.

Due to the bend 7b of the back portion 7, the picking platform 8 is displaced in the direction of the back portion 7 and fully covers the retainer spring 6 in a vertical direction V. The width W2 of the connecting portions 4 is smaller than the width W1 of the picking platform 8. Thus, objects approaching in a vertical direction V are diverted by the picking platform 8 and cannot impact or deflect the retainer spring 6.

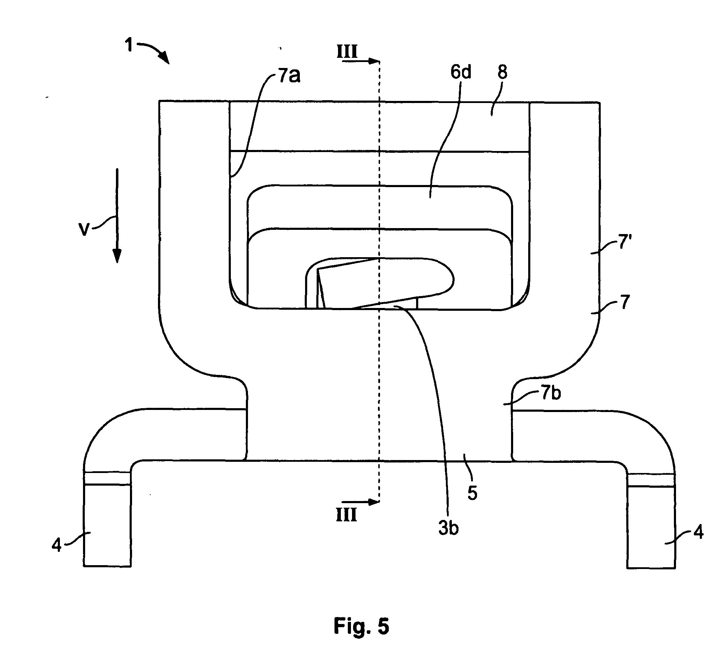

Fig. 5 is a schematic back view of a terminal 1 according to the invention. The back portion 7 constitutes a frame 7' for supporting the picking platform 8 and to provide space for a resilient movement of the retainer spring 6. The frame-like structure of the terminal, which is realized by the back portion frame 7' and the retainer spring frame 6d, and the substantially symmetric shape of the terminal 1 reinforce the terminal 1 and thereby improve the utilization of material.

To facilitate bending of the terminal, the back portion 7 tapers in vertical direction V into a tapered portion 7b, which merges into the base portion 5 and which is bent against mounting direction M to form the back portion 7. Accordingly, also the connecting portions 4, the retainer spring 6, and the picking platform 8 are bent at tapered portions, which taper in the direction of the base portion 5.

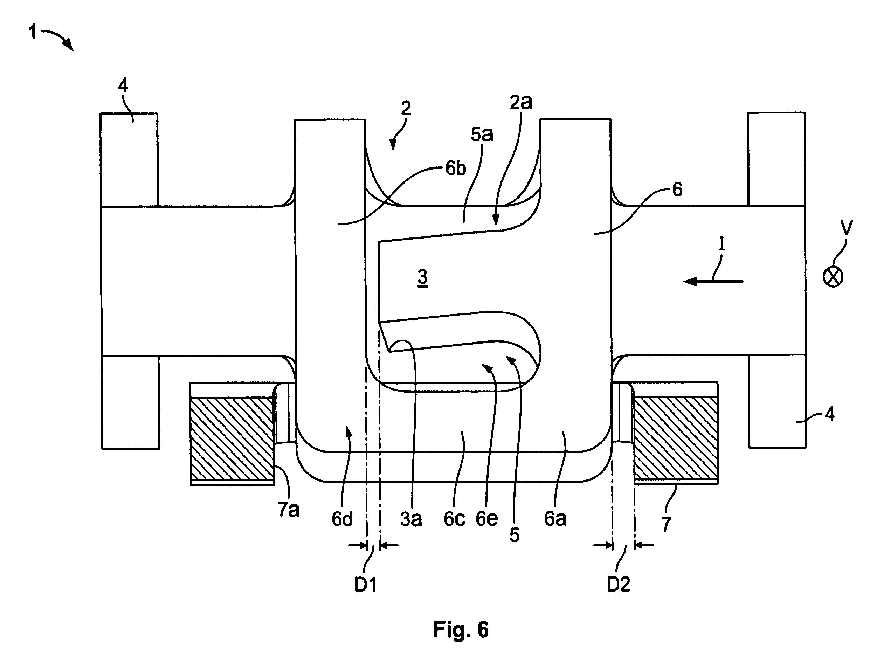

Fig. 6 is a schematic cross-sectional top view of the terminal 1 according to section plane VI-VI of Fig. 4. The substantially rectangular wire retainer 3 protrudes from the spring leg 6a into the opening 6e. The wire retainer 3 is arranged at a distance D1 with respect to the spring leg 6b, to allow for deflecting the wire retainer 3 in or against the vertical direction V without abutting the spring leg 6b. Due to distances D2 between the inner side of the aperture 7a and the retainer spring 6, the retainer spring 6 does not abut the back portion 7, even if the retainer spring 6 is deflected.

The spring legs 6a, 6b and the coupling portion 6c, which extends between the spring legs 6a, 6b, constitute a closed frame 6d. The frame 6d forms a resilient clamp which generates the retaining force B (see Fig. 4) acting on the wire retainer 3 when a wire is received by the wire receptacle 2.

During insertion of a wire in Insertion direction I, the release force R (see Fig. 4) is generated by the wire and deflects the retainer spring 6 to widen the wire receptacle 2. As wire retainer 3 is slanted with respect to the insertion direction I, the retainer 3 protrudes into the wire chamber 2a. An inner face 3b (Fig. 5) of the retainer 3 extends into the wire chamber 2a and, together with an inner face 5a of the base portion 5 forms a funnel which tapers in insertion direction I. A wire which is moved in insertion direction I into the wire chamber 2a abuts the inner faces 3b and 5a and moves the retainer 3 out of the wire chamber 2a.

The wire retainer 3 is provided with a holding portion 3a which, at a mated state of the terminal 1, engages the wire frictionally and/or by a positive lock. The holding portion 3a may be constituted by an edge of the retainer 3 pointing into the wire chamber 2a and pressing onto the wire.

## Claims

1. Poke-in terminal (1) for electrically connecting at least one wire to a printed circuit board, comprising at least one connecting portion (4) for mounting the terminal (1) on the printed circuit board, and a wire receptacle (2) for receiving the wire (11) in an insertion direction (I), the wire receptacle (2) comprising a wire chamber (2a) and a wire retainer (3), wherein the terminal (1) is provided with a retainer spring (6) resiliently supporting the wire retainer (3) and wherein the wire retainer (3), at least at an unmated state of the terminal (1), extends into the wire chamber (2a) and is adapted to be deflected resiliently by the wire (11) in an outward direction (O), **characterized in that** the retainer spring (6) has at least one spring leg (6a, 6b), the spring leg (6a, 6b) extending substantially perpendicularly to the insertion direction (I).

2. Terminal (1) according to claim 1, **characterized in that** the wire retainer (3) and the retainer spring (6) are configured to be deflected resiliently, the wire retainer (3) being configured to be less deflected than the retainer spring (6) by a predetermined insertion force (F) acting on the wire retainer (3).

3. Terminal (1) according to claim 1 or 2, **characterized in that** the wire retainer (3) and the retainer spring (6) are configured to act simultaneously on a wire (11) received by the wire receptacle (2).

4. Terminal (1) according to one of claims 1 to 3, **characterized in that** the wire retainer (3) protrudes from the retainer spring (6) substantially in insertion direction (I).

5. Terminal (1) according to one of claims 1 to 4, **characterized in that** the retainer spring (6) is provided with an opening (6e), the wire retainer (3) protruding into the opening (6e).

6. Terminal (1) according to claim 5, **characterized in that** the opening (6e) is framed by the least one spring leg (6a, 6b).

7. Terminal (1) according to one of claims 1 to 6, **characterized in that** the retainer spring (6) is provided with two spring legs (6a, 6b), the spring legs (6a, 6b) extending in parallel with each other.

8. Terminal (1) according to one of claims 1 to 7, **characterized In that** the terminal (1) comprises a base portion (5) which borders on the wire chamber (2a), the retainer spring (6) and the connecting portion (4) protruding from the base portion (5).

9. Terminal (1) according to one of claims 1 to 8, **characterized in that** the terminal (1) comprises a back portion (7), the back portion (7) and the retainer spring (6) extending from the base portion (5) on opposite sides of the base portion (5).

10. Terminal (1) according to claim 9, **characterized in that** the terminal (1) is provided with a picking platform (8), the picking platform (8) protruding from the back portion (7) and constituting a picking face (8a), the picking face (8a) extending substantially perpendicularly to a mounting direction (M).

11. Terminal (1) according to claim 9 or 10, **characterized in that** the back portion (7) is provided with an aperture (7a), the retainer spring (6) extending into the aperture (7a).

12. Terminal (1) according to one of claims 1 to 11, **characterized in that** the at least one connecting portion (4) protrudes from a base portion (5) in mounting direction (M).

13. Terminal (1) according to one of claims 1 to 12, **characterized in that** the terminal (1) is integrally formed from one piece of sheet metal (1').

14. Terminal (1) according to one of claims 1 to 13, **characterized in that** the wire chamber (2a) has a polygonal shape (9).

15. Terminal (1) according to one of claims 1 to 14, **characterized in that** the polygonal shape (9) borders a circular area (10) of 0,25 mm² or less.

## Patentansprüche

1. Einsteckanschluss (1) zum elektrischen Verbinden wenigstens eines Drahtes mit einer Leiterplatte, der wenigstens einen Verbindungsabschnitt (4) zum Montieren des Anschlusses (1) an der Leiterplatte sowie eine Draht-Aufnahme (2) zum Aufnehmen des Drahtes (11) in einer Einführrichtung (I) umfasst, wobei die Draht-Aufnahme (2) eine Draht-Kammer (2a) sowie einen Draht-Halter (3) umfasst und der Anschluss (1) mit einer Halter-Feder (6) versehen ist, die den Draht-Halter (3) elastisch trägt, und sich der Draht-Halter (3), wenigstens in einem eingriffslosen Zustand des Anschlusses (1), in die Draht-Kammer (2a) hinein erstreckt und so eingerichtet ist, dass er durch den Draht (11) elastisch in einer Auswärts-Richtung (O) gebogen wird, **dadurch gekennzeichnet, dass** die Halter-Feder (6) wenigstens einen Federschenkel (6a, 6b) hat und sich der Federschenkel (6a, 6b) im Wesentlichen senkrecht zu der Einführrichtung (I) erstreckt.

2. Anschluss (1) nach Anspruch 1, **dadurch gekennzeichnet, dass** der Draht-Halter (3) und die Halter-Feder (6) so eingerichtet sind, dass sie elastisch gebogen werden, wobei der Draht-Halter (3) so eingerichtet ist, dass er durch eine vorgegebene Einführungskraft (F), die auf den Draht-Halter (3) wirkt, weniger gebogen wird als die Halter-Feder (6).

3. Anschluss (1) nach Anspruch 1 oder 2, **dadurch gekennzeichnet, dass** der Draht-Halter (3) und die Halter-Feder (6) so eingerichtet sind, dass sie gleichzeitig auf einen von der Draht-Aufnahme (2) aufgenommenen Draht (11) einwirken.

4. Anschluss (1) nach einem der Ansprüche 1 bis 3, **dadurch gekennzeichnet, dass** der Draht-Halter (3) von der Halter-Feder (6) im Wesentlichen in Einführrichtung (I) vorsteht.

5. Anschluss (1) nach einem der Ansprüche 1 bis 4, **dadurch gekennzeichnet, dass** die Halter-Feder (6) mit einer Öffnung (6e) versehen ist und der Draht-Halter (3) in die Öffnung (6e) hinein vorsteht.

6. Anschluss (1) nach Anspruch 5, **dadurch gekennzeichnet, dass** die Öffnung (6e) von dem wenigstens einen Federschenkel (6a, 6b) eingerahmt wird.

7. Anschluss (1) nach einem der Ansprüche 1 bis 6, **dadurch gekennzeichnet, dass** die Halter-Feder (6) mit zwei Federschenkeln (6a, 6b) versehen ist und sich die Federschenkel (6a, 6b) parallel zueinander erstrecken.

8. Anschluss (1) nach einem der Ansprüche 1 bis 7, **dadurch gekennzeichnet, dass** der Anschluss (1) einen Basisabschnitt (5) umfasst, der an die Draht-Kammer (2a) angrenzt, wobei die Halter-Feder (6) und der Verbindungsabschnitt (4) von dem Basisabschnitt (5) vorstehen.

9. Anschluss (1) nach einem der Ansprüche 1 bis 8, **dadurch gekennzeichnet, dass** der Anschluss (1) einen hinteren Abschnitt (7) umfasst, wobei sich der hintere Abschnitt (7) und die Halter-Feder (6) an einander gegenüberliegenden Seiten des Basisabschnitts (5) von dem Basisabschnitt (5) aus erstrecken.

10. Anschluss (1) nach Anspruch 9, **dadurch gekennzeichnet, dass** der Anschluss (1) mit einer Aufnahme-Plattform (picking platform) (8) versehen ist, wobei die Aufnahme-Plattform (8) von dem hinteren Abschnitt (7) vorsteht und eine Aufnahme-Fläche (8a) bildet, und sich die Aufnahme-Fläche (8a) im Wesentlichen senkrecht zu einer Montierrichtung (M) erstreckt.

11. Anschluss (1) nach Anspruch 9 oder 10, **dadurch gekennzeichnet, dass** der hintere Abschnitt (7) mit einem Loch (7a) versehen ist und sich die Halter-Feder (6) in das Loch (7a) hinein erstreckt.

12. Anschluss (1) nach einem der Ansprüche 1 bis 11, **dadurch gekennzeichnet, dass** der wenigstens eine Verbindungsabschnitt (4) von einem Basisabschnitt (5) in Montierrichtung (M) vorsteht.

13. Anschluss (1) nach einem der Ansprüche 1 bis 12, **dadurch gekennzeichnet, dass** der Anschluss (1) integral aus einem Stück Blech (1') ausgebildet ist.

14. Anschluss (1) nach einem der Ansprüche 1 bis 13, **dadurch gekennzeichnet, dass** die Draht-Kammer (2a) eine polygonale Form (9) hat.

15. Anschluss (1) nach einem der Ansprüche 1 bis 14, **dadurch gekennzeichnet, dass** die polygonale Form (9) eine kreisförmige Fläche (10) von 0,25 mm² oder weniger begrenzt.

## Revendications

1. Borne enfichable (1) pour connecter électriquement au moins un fil à une carte de circuit imprimé, comprenant au moins une partie de connexion (4) pour monter la borne (1) sur la carte de circuit imprimé, et un réceptacle de fil (2) pour recevoir le fil (11) dans une direction d'insertion (I), le réceptacle de fil (2) comprenant une chambre de fil (2a) et un dispositif de retenue de fil (3), dans laquelle la borne (1) est munie d'un ressort de retenue (6) supportant de manière élastique le dispositif de retenue de fil (3) et dans laquelle le dispositif de retenue de fil (3), au moins dans un état non accouplé de la borne (1), s'étend dans la chambre de fil (2a) et est adapté à être dévié de manière élastique vers l'extérieur (O) par le fil (11), **caractérisée en ce que** le ressort de retenue (6) possède au moins une patte de ressort (6a, 6b), la patte de ressort (6a, 6b) s'étendant sensiblement perpendiculairement à la direction d'insertion (I).

2. Borne (1) selon la revendication 1, **caractérisée en ce que** le dispositif de retenue de fil (3) et le ressort de retenue (6) sont configurés de façon à être déviés de manière élastique, le dispositif de retenue de fil (3) étant configuré pour être moins dévié que le ressort de retenue (6) par une force d'insertion prédéterminée (F) agissant sur le dispositif de retenue de fil (3).

3. Borne (1) selon la revendication 1 ou 2, **caractérisée en ce que** le dispositif de retenue de fil (3) et le ressort de retenue (6) sont configurés pour agir simultanément sur un fil (11) reçu par le réceptacle de fil (2).

4. Borne (1) selon l'une des revendications 1 à 3, **caractérisée en ce que** le dispositif de retenue de fil (3) fait saillie depuis le ressort de retenue (6) sensiblement dans la direction d'insertion (I).

5. Borne (1) selon l'une des revendications 1 à 4, **caractérisée en ce que** le ressort de retenue (6) est muni d'une ouverture (6e), le dispositif de retenue de fil (3) faisant saillie dans l'ouverture (6e).

6. Borne (1) selon la revendication 5, **caractérisée en ce que** l'ouverture (6e) est encadrée par l'au moins une patte de ressort (6a, 6b).

7. Borne (1) selon l'une des revendications 1 à 6, **caractérisée en ce que** le ressort de retenue (6) est muni de deux pattes de ressort (6a, 6b), les pattes de ressort (6a, 6b) s'étendant en parallèle entre elles.

8. Borne (1) selon l'une des revendications 1 à 7, **caractérisée en ce que** la borne (1) comprend une partie de base (5) qui borde la chambre de fil (2a), le ressort de retenue (6) et la partie de connexion (4) faisant saillie depuis la partie de base (5).

9. Borne (1) selon l'une des revendications 1 à 8, **caractérisée en ce que** la borne (1) comprend une partie arrière (7), la partie arrière (7) et le ressort de retenue (6) s'étendant depuis la partie de base (5) sur les faces opposées de la partie de base (5).

10. Borne (1) selon la revendication 9, **caractérisée en ce que** la borne (1) est munie d'une plate-forme de prise (8), la plate-forme de prise (8) faisant saillie depuis la partie arrière (7) et constituant une face de prise (8a), la face de prise (8a) s'étendant sensiblement perpendiculairement à la direction de montage (M).

11. Borne (1) selon la revendication 9 ou 10, **caractérisée en ce que** la partie arrière (7) est munie d'une ouverture (7a), le ressort de retenue (6) s'étendant dans l'ouverture (7a).

12. Borne (1) selon l'une des revendications 1 à 11, **caractérisée en ce que** l'au moins une partie de connexion (4) fait saillie depuis une partie de base (5) dans la direction de montage (M).

13. Borne (1) selon l'une des revendications 1 à 12, **caractérisée en ce que** la borne (1) est formée de manière intégrée à partir d'un morceau de tôle métallique (1').

14. Borne (1) selon l'une des revendications 1 à 13, **caractérisée en ce que** la chambre de fil (2a) possède une forme polygonale (9).

15. Borne (1) selon l'une des revendications 1 à 14, **caractérisée en ce que** la forme polygonale (9) borde une aire circulaire (10) inférieure ou égale à 0,25 mm².
